# EUROPEAN PATENT APPLICATION

(11) **EP 4 672 887 A1**
(43) Date of publication of application: **31.12.2025**
(21) Application number: 25179504.3
(22) Date of filing: 28.05.2025
(51) Int. Cl.: H05K 7/20, H02M 7/00, H02M 7/5387

(54) **MOTOR CONTROLLER INTEGRATED MODULE, POWER SUPPLY APPARATUS, AND ELECTRIC VEHICLE**

(30) Priority: 29.05.2024 CN 202421204863 U
(71) Applicant: Huawei Digital Power Technologies Co., Ltd., Shenzhen, Guangdong 518043 (CN)
(72) Inventor: XU, Yankun, Shenzhen, 518043 (CN); XIAO, Longxing, Shenzhen, 518043 (CN); ZHANG, Xueliang, Shenzhen, 518043 (CN); DAI, Jinyan, Shenzhen, 518043 (CN); DU, Lin, Shenzhen, 518043 (CN)
(74) Representative: Gill Jennings & Every LLP

(57) **Abstract**

This application provides a motor controller integrated module, a power supply apparatus, and an electric vehicle. A bus capacitor, a heat sink, and two power assemblies are integrated into the motor controller integrated module. The bus capacitor includes a housing and a capacitor core package. The housing includes an accommodating groove. The accommodating groove is configured to accommodate the capacitor core package. A length of the capacitor core package in a width direction of the capacitor core package is less than a length of the capacitor core package in a length direction of the capacitor core package. A peripheral groove wall of the accommodating groove includes two first side walls that are opposite in the width direction of the capacitor core package. The two power assemblies and a heat dissipation plate of the heat sink are stacked in the width direction of the capacitor core package and arranged on a side that is of one first side wall and that is away from the other first side wall. Each power assembly includes three power modules. A thickness direction of each power module is parallel to the width direction of the capacitor core package. The arrangement manner in which the bus capacitor and the two power assemblies are stacked reduces a size of the motor controller integrated module, thereby reducing a size of the power supply apparatus, and optimizing a layout of the entire vehicle.

## Description

### TECHNICAL FIELD

This application relates to the field of electric vehicle technologies, and in particular, to a motor controller integrated module, a power supply apparatus, and an electric vehicle.

### BACKGROUND

In the current hybrid field of electric vehicles, a powertrain includes a motor, a generator, and a motor controller. The motor controller has two power assemblies configured to electrically connect to the motor and the generator. As a result, a quantity of electrical components in the motor controller increases, and arrangement is complex. Because the powertrain is arranged in a front compartment, a space size requirement is high, and reduction of a size of the motor controller having two power assemblies is an important difficulty of a miniaturization design of the powertrain. At present, the two power assemblies are usually tiled in the motor controller, resulting in problems of low space utilization, low integration, complex production and processing procedures, and high costs.

### SUMMARY

This application provides a motor controller integrated module, a power supply apparatus, and an electric vehicle.

According to a first aspect, this application provides a motor controller integrated module. A bus capacitor, a heat sink, and two power assemblies are integrated into the motor controller integrated module, the bus capacitor includes a housing and a capacitor core package, the housing is configured to fasten the heat sink and the two power assemblies, each power assembly is configured to implement mutual conversion between a direct current and a three-phase alternating current, the capacitor core package is configured to electrically connect to an end that is of each power assembly and that transmits the direct current, and the heat sink is configured to cool the two power assemblies. The housing includes an accommodating groove, the accommodating groove is configured to accommodate the capacitor core package, a length of the capacitor core package in a width direction of the capacitor core package is less than a length of the capacitor core package in a length direction of the capacitor core package, a peripheral groove wall of the accommodating groove includes two first side walls, and the two first side walls are opposite to each other in the width direction of the capacitor core package. The heat sink includes a heat dissipation plate. In the width direction of the capacitor core package, the two power assemblies and the heat dissipation plate are stacked and arranged on a side that is of one first side wall and that is away from the other first side wall. Each power assembly includes three power modules, the three power modules are sequentially arranged and spaced apart in the length direction of the capacitor core package, and a thickness direction of each power module is parallel to the width direction of the capacitor core package.

In embodiments of this application, in the motor controller integrated module, the length of the capacitor core package in the width direction of the capacitor core package is set to be relatively small, so that the capacitor core package occupies relatively small space of the motor controller integrated module in the width direction of the capacitor core package, and space of the capacitor core package in the width direction of the capacitor core package can be reserved for arranging the heat sink and the two power assemblies. The two power assemblies and the heat dissipation plate are stacked and arranged on an outer side of the one first side wall of the accommodating groove in the width direction, and the thickness direction of each power module is parallel to the width direction of the capacitor core package, so that the two power assemblies and the heat dissipation plate are more compactly arranged on a side of the capacitor core package in the width direction of the capacitor core package. In this way, the two power assemblies and the heat dissipation plate do not occupy excessive space of the motor controller integrated module in the length direction of the capacitor core package, so that the motor controller integrated module has a relatively small size in both the width direction of the capacitor core package and the length direction of the capacitor core package. Therefore, an overall size of the motor controller integrated module is small, and a size of the power supply apparatus is small. This facilitates a layout of the power supply apparatus in the entire vehicle.

In an embodiment, the length of the capacitor core package in the length direction of the capacitor core package is greater than a sum of lengths of the two power assemblies and the heat dissipation plate in the width direction of the capacitor core package.

In embodiments of this application, the length of the capacitor core package in the length direction of the capacitor core package is greater than the sum of the lengths of the two power assemblies and the heat dissipation plate in the width direction of the capacitor core package, so that although the two power assemblies and the heat dissipation plate are stacked and arranged on the one first side wall in the width direction of the capacitor core package, space of the motor controller integrated module in the width direction of the capacitor core package is not occupied excessively. This helps avoid a relatively large overall size of the motor controller integrated module when the two power assemblies, the heat dissipation plate, and the capacitor core package are integrated, and is conducive to a miniaturization layout of the motor controller integrated module.

In an embodiment, a length of the one first side wall in the length direction of the capacitor core package is greater than a distance between the two first side walls in the width direction of the capacitor core package, and the length of the one first side wall in the length direction of the capacitor core package is greater than the sum of the lengths of the two power assemblies and the heat dissipation plate in the width direction of the capacitor core package.

In embodiments of this application, the length of the one first side wall in the length direction of the capacitor core package is greater than the distance between the two first side walls in the width direction of the capacitor core package. Space occupied by the two first side walls of the accommodating groove in the width direction of the capacitor core package is very small. This helps the capacitor core package between the two first side walls have a small size in the width direction of the capacitor core package. The length of the one first side wall in the length direction of the capacitor core package is greater than the sum of the lengths of the two power assemblies and the heat dissipation plate in the width direction of the capacitor core package. Space occupied by the two power assemblies and the heat dissipation plate in the width direction of the capacitor core package is relatively small. This facilitates miniaturization of the motor controller integrated module in the width direction of the capacitor core package.

In an embodiment, the capacitor core package, the one first side wall, one power assembly, the heat dissipation plate, and the other power assembly are sequentially arranged in the width direction of the capacitor core package.

In embodiments of this application, the capacitor core package, the one first side wall, the power assembly, the heat dissipation plate, and the other power assembly are sequentially arranged in the width direction of the capacitor core package, so that the capacitor core package, the power assembly, the heat dissipation plate, and the other power assembly do not occupy excessive space of the motor controller integrated module in the length direction of the capacitor core package. In this way, the motor controller integrated module has a small size in the length direction of the capacitor core package. This facilitates a miniaturization layout of the motor controller integrated module in the power supply apparatus, so as to optimize a layout of the entire vehicle. In addition, in the width direction of the capacitor core package, the heat dissipation plate is arranged between the power assembly and the other power assembly, so that the heat dissipation plate can simultaneously dissipate heat for the two power assemblies, and heat generated by the two power assemblies can be absorbed by the heat dissipation plate through a short path, thereby helping improve efficiency of cooling the two power assemblies by the heat dissipation plate.

In an embodiment, the heat sink further includes a bottom plate. The bottom plate includes two holes, and the two holes are used to communicate with an internal flow channel of the heat dissipation plate through an internal flow channel of the bottom plate. In the width direction of the capacitor core package, the bottom plate is arranged on a side that is of the two power assemblies and the heat dissipation plate and that is away from the capacitor core package. Orientations of openings of the two holes are the same as an orientation of a groove opening of the accommodating groove.

In embodiments of this application, the bottom plate includes the two holes, and the two holes are used to receive coolant from an external cooling circulation system and output coolant that absorbs heat and heats up in the heat sink. The two holes are used to communicate with the internal flow channel of the heat dissipation plate through the internal flow channel of the bottom plate. The internal flow channels of the heat dissipation plate and the bottom plate communicate through the two holes, so that the coolant in the heat sink can flow smoothly. The bottom plate may also cool a power assembly adjacent to the bottom plate.

In embodiments of this application, in the width direction of the capacitor core package, the bottom plate is arranged on the side that is of the two power assemblies and the heat dissipation plate and that is away from the capacitor core package, so that the bottom plate can directly cool the other power assembly in the two power assemblies. Compared with arranging the bottom plate on a side that is of the two power assemblies and the heat dissipation plate and that is close to the capacitor core package, arranging the bottom plate on the side that is of the two power assemblies and the heat dissipation plate and that is away from the capacitor core package helps shorten a distance of an electrical connection between the capacitor core package and the two power assemblies, and also helps implement a copper bar electrical connection between the capacitor core package and the two power assemblies. The orientations of the openings of the two holes are the same as the orientation of the groove opening of the accommodating groove, so that a position in which the heat sink is connected to an external water channel is in an arrangement direction of the groove opening and the groove bottom of the accommodating groove, and does not occupy a position of the motor controller integrated module in the width direction and the length direction of the capacitor core package, thereby helping reduce a size of the motor controller integrated module.

In an embodiment, the housing further includes two fastening protrusions, the two fastening protrusions are configured to fasten an electrical component, the two fastening protrusions protrude from the one first side wall away from the capacitor core package in the width direction of the capacitor core package, and space between the two fastening protrusions is used to accommodate the heat sink and the two power assemblies. In the length direction of the capacitor core package, a distance between the two fastening protrusions is greater than a length of the heat sink or each power assembly. In the width direction of the capacitor core package, a length of each fastening protrusion is greater than a sum of lengths of the heat sink and the two power assemblies.

In embodiments of this application, in the length direction of the capacitor core package, the distance between the two fastening protrusions is greater than the length of the heat sink or each power assembly, and arrangement space of the heat sink and the two power assemblies in the length direction of the capacitor core package is relatively small, so that a size of the motor controller integrated module in the length direction of the capacitor core package is relatively small. In the width direction of the capacitor core package, the length of each fastening protrusion is greater than the sum of the lengths of the heat sink and the two power assemblies, so that the heat sink and the two power assemblies are all disposed in the housing of the motor controller integrated module in the width direction of the capacitor core package, and the motor controller integrated module does not occupy excessive space of the housing in the width direction of the capacitor core package. In this way, the motor controller integrated module has a relatively small size in both the width direction and the length direction of the capacitor core package.

In an embodiment, each power module includes two input copper bars and an output copper bar, the two input copper bars are configured to be electrically connected to the capacitor core package to receive a direct current, and the output copper bar is configured to output a one-phase alternating current. The two input copper bars are arranged opposite to the output copper bar in an arrangement direction of a groove bottom and the groove opening of the accommodating groove, the two input copper bars are on a same side as the groove opening of the accommodating groove, the two input copper bars of each power module are arranged and spaced apart in the length direction of the capacitor core package, and each input copper bar is bent toward the one first side wall in the width direction of the capacitor core package.

In embodiments of this application, in the arrangement direction of the groove bottom and the groove opening of the accommodating groove, the two input copper bars are arranged opposite to the output copper bar, so that a current in each power module may be transmitted in the arrangement direction of the groove bottom and the groove opening of the accommodating groove. The two input copper bars are on the same side as the groove opening of the accommodating groove. This facilitates direct current transmission between the two input copper bars of each power module and the capacitor core package. The two input copper bars of each power module are arranged and spaced apart in the length direction of the capacitor core package, to avoid electrical connection interference between the two input copper bars of each power module. Each input copper bar is bent toward the one first side wall in the width direction of the capacitor core package, so that each input copper bar is electrically connected to the capacitor core package on the other side of the one first side wall, and each power module does not occupy excessive space of the motor controller integrated module in the arrangement direction of the groove bottom and the groove opening of the accommodating groove.

In an embodiment, the bus capacitor further includes two input connection copper sheets, one input connection copper sheet is configured to electrically connect a positive electrode of the capacitor core package and the input copper bar of each power module, and the other input connection copper sheet is configured to electrically connect a negative electrode of the capacitor core package and the other input copper bar of each power module. In the arrangement direction of the groove bottom and the groove opening of the accommodating groove, the two input connection copper sheets are stacked and spaced apart in an insulating manner. In the arrangement direction of the groove bottom and the groove opening of the accommodating groove, the two input connection copper sheets are stacked on the two input copper bars of each power module.

In embodiments of this application, in the arrangement direction of the groove bottom and the groove opening of the accommodating groove, the two input connection copper sheets are stacked and spaced apart in an insulating manner, and the two input connection copper sheets are stacked. The input connection copper sheet is connected to the positive electrode of the capacitor core package, and the other input connection copper sheet is connected to the negative electrode of the capacitor core package, so that current directions of the two input connection copper sheets are opposite. When the two input connection copper sheets are stacked, magnetic fields generated by the two input connection copper sheets in opposite current directions may partially offset each other, thereby reducing stray inductance generated by the two input connection copper sheets, so that the bus capacitor is applicable to application of the motor controller integrated module. The two input connection copper sheets are stacked on the two input copper bars of each power module in the arrangement direction of the groove bottom and the groove opening of the accommodating groove. This helps reduce space occupied by the two input connection copper bars and the two input copper bars of each power module in the width direction and the length direction of the capacitor core package.

In an embodiment, three power modules in one power assembly are respectively aligned with three power modules in the other power assembly in the width direction of the capacitor core package, each input connection copper sheet includes three pairs of connection holes and three pairs of avoidance holes, two connection holes in each pair of connection holes of the input connection copper sheet each are configured to connect to one input copper bar of two power modules that are aligned in the width direction of the capacitor core package, and two avoidance holes in each pair of avoidance holes of the input connection copper sheet are respectively configured to pass through connectors that connect a pair of connection holes of the other input connection copper sheet and the other input copper bars of the two power modules. The three pairs of connection holes and the three pairs of avoidance holes in each input connection copper sheet are alternately arranged in sequence in the length direction of the capacitor core package. In the arrangement direction of the groove bottom and the groove opening of the accommodating groove, the three pairs of connection holes of the input connection copper sheet are respectively aligned with the three pairs of avoidance holes of the other input connection copper sheet.

In embodiments of this application, three power modules in one power assembly are respectively aligned with three power modules in the other power assembly in the width direction of the capacitor core package. This helps reduce space occupied by the two power assemblies in the length direction of the capacitor core package. The three pairs of connection holes and the three pairs of avoidance holes in each input connection copper sheet are alternately arranged in sequence in the length direction of the capacitor core package, so that three power modules in each power assembly connected to each input connection copper sheet are sequentially arranged and spaced apart in the length direction of the capacitor core package, and three power modules in one power assembly are respectively aligned with three power modules in the other power assembly in the width direction of the capacitor core package. In this way, space occupied by the two power assemblies in the length direction and the width direction of the capacitor core package is reduced. In the arrangement direction of the groove bottom and the groove opening of the accommodating groove, the three pairs of connection holes of the input connection copper sheet are respectively aligned with the three pairs of avoidance holes of the other input connection copper sheet, so that the two input connection copper sheets can be stacked in the arrangement direction of the groove bottom and the groove opening of the accommodating groove and spaced apart in an insulating manner, thereby helping reduce space occupied by the two input connection copper bars in the width direction and the length direction of the capacitor core package.

In embodiments of this application, two connection holes in each pair of connection holes of the input connection copper sheet each are configured to connect to one input copper bar of two power modules that are aligned in the width direction of the capacitor core package, and two avoidance holes in each pair of avoidance holes of the input connection copper sheet are respectively configured to pass through connectors that connect a pair of connection holes of the other input connection copper sheet and the other input copper bars of the two power modules, so that the input connection copper sheet can be electrically connected to the two power assemblies stacked in the width direction of the capacitor core package. In addition, sharing the input connection copper sheet and the other input connection copper sheet can improve integration of the motor controller integrated module.

In an embodiment, the two connection holes in each pair of connection holes are arranged in the width direction of the capacitor core package, and two avoidance holes in a pair of avoidance holes are arranged in the width direction of the capacitor core package. Each avoidance hole is aligned with one connection hole in the arrangement direction of the groove bottom and the groove opening of the accommodating groove. A hole diameter of each avoidance hole is greater than a hole diameter of the connection hole aligned with the avoidance hole.

In embodiments of this application, in the arrangement direction of the groove bottom and the groove opening of the accommodating groove, each avoidance hole is aligned with one connection hole, so that when two avoidance holes in each pair of avoidance holes of the input connection copper sheet are connected to the connectors that connect a pair of connection holes of the other input connection copper sheet and the other input copper bars of two power modules, there is no need to occupy more space in the width direction and the length direction of the capacitor core package.

In embodiments of this application, the hole diameter of each avoidance hole is greater than the hole diameter of the connection hole aligned with the avoidance hole, so that an insulating separator is conveniently inserted through each avoidance hole, and an electrical connection between the two input connection copper sheets is avoided.

In an embodiment, the output copper bar of each power module is bent toward the one first side wall in the width direction of the capacitor core package, the motor controller integrated module further includes two groups of output connection copper sheets, each group of output connection copper sheets includes three output connection copper sheets, and the three output connection copper sheets in each group of output connection copper sheets each are configured to connect to one output copper bar of the three power modules of each power assembly. In the arrangement direction of the groove bottom and the groove opening of the accommodating groove, the three output connection copper sheets in each group of output connection copper sheets and the output copper bar of each power module are arranged on a same side and stacked on the two power assemblies and the heat sink. The three output connection copper sheets in each group of output connection copper sheets extend away from the one first side wall in the width direction of the capacitor core package. The three output connection copper sheets in one group of output connection copper sheets and the three output connection copper sheets in the other group of output connection copper sheets are alternately arranged in sequence in the length direction of the capacitor core package.

In embodiments of this application, the output copper bar of each power module is bent toward the one first side wall in the width direction of the capacitor core package. This helps reduce space occupied by the output copper bar of each power module in the arrangement direction of the groove bottom and the groove opening of the accommodating groove. In the arrangement direction of the groove bottom and the groove opening of the accommodating groove, the three output connection copper sheets in each group of output connection copper sheets and the output copper bar of each power module are arranged on the same side, so that an alternating current output by the output copper bar of each power module is smoothly output out of the motor controller integrated module from the three output connection copper sheets through a short path. Each group of output connection copper sheets is stacked on the two power assemblies and the heat sink, so that each group of output connection copper sheets is electrically connected to the output copper bar of each power module, and space occupied by each group of output connection copper sheets in the width direction of the capacitor core package and the length direction of the capacitor core package is further reduced.

In embodiments of this application, three output connection copper sheets in the group of output connection copper sheets and three output connection copper sheets in the other group of output connection copper sheets are alternately arranged in sequence in the length direction of the capacitor core package. This helps simplify connection arrangement between the two groups of output connection copper sheets and the output copper bar of each power module of the two power assemblies, and further helps shorten a connection path between the two groups of output connection copper sheets and the output copper bar of each power module of the two power assemblies, thereby saving copper bar materials.

In an embodiment, a circuit board is further integrated into the motor controller integrated module, and the housing is configured to fasten the circuit board. In the arrangement direction of the groove bottom and the groove opening of the accommodating groove, the circuit board is stacked on the housing, the heat sink, and each power module, and the circuit board, the groove bottom of the accommodating groove, and the capacitor core package are sequentially arranged.

In embodiments of this application, in the arrangement direction of the groove bottom and the groove opening of the accommodating groove, the circuit board is stacked on the housing, the heat sink, and each power module, the circuit board, the groove bottom of the accommodating groove, and the capacitor core package are sequentially arranged, and the circuit board is located on an outer side of the groove bottom of the accommodating groove of the housing, so that each power module is plugged into the circuit board through a signal connector cable, to implement an electrical connection, without a need to arrange an additional line to connect the power module and the circuit board, which causes an increase in a size of the motor controller integrated module.

In an embodiment, an EMC filter is further integrated into the motor controller integrated module, the EMC filter and the bus capacitor are configured to perform filtering and voltage regulation on the direct current, the peripheral groove wall of the accommodating groove further includes two second side walls, the two second side walls are arranged oppositely in the length direction of the capacitor core package, the capacitor core package includes two groups of capacitor cores, and one second side wall, one group of capacitor cores, the other group of capacitor cores, and the other second side wall are sequentially arranged in the length direction of the capacitor core package. In the width direction of the capacitor core package, a length of the one group of capacitor cores is greater than a length of the other group of capacitor cores. In the width direction of the capacitor core package, a part of the other first side wall that is opposite to the other group of capacitor cores is recessed toward the other group of capacitor cores compared with another part of the other first side wall that is opposite to the one group of capacitor cores, and space that is of the part of the other first side wall and that is away from the other group of capacitor cores is used to accommodate the EMC filter.

In embodiments of this application, in the width direction of the capacitor core package, the length of the one group of capacitor cores is greater than the length of the other group of capacitor cores, so that space is provided for the EMC filter to be integrated into the motor controller integrated module, thereby improving integration of the power supply apparatus, and avoiding an excessively large size of the power supply apparatus. Arrangement of the two groups of capacitor cores needs only to satisfy that the length of the one group of capacitor cores is greater than the length of the other group of capacitor cores in the width direction of the capacitor core package, so that the EMC filter has sufficient space to be integrated into the motor controller integrated module.

In embodiments of this application, in the width direction of the capacitor core package, a part of the other first side wall that is opposite to the other group of capacitor cores is recessed toward the other group of capacitor cores compared with another part of the other first side wall that is opposite to the group of capacitor cores, and space that is of the part of the other first side wall and that is away from the other group of capacitor cores is used to accommodate the EMC filter. This helps fully utilize space in the motor controller integrated module to integrate the EMC filter, and helps improve integration of the motor controller integrated module.

According to a second aspect, this application provides a power supply apparatus. The power supply apparatus includes a housing and the motor controller integrated module according to the first aspect, and an internal flow channel of the housing is configured to communicate with an internal flow channel of the heat sink in the motor controller integrated module.

In embodiments of this application, the motor controller integrated module is arranged in a manner in which the bus capacitor and the two power assemblies are stacked in the width direction of the capacitor core package, and the motor controller integrated module has a relatively small size in the length direction of the capacitor core package, and also has a relatively small size in the width direction of the capacitor core package. This helps reduce an overall size of the motor controller integrated module, and further reduce the size of the power supply apparatus, thereby helping optimize the layout of the entire vehicle. The internal flow channel of the housing of the power supply apparatus communicates with the internal flow channel of the heat sink in the motor controller integrated module, so that the integration of the power supply apparatus is higher.

According to a third aspect, this application provides an electric vehicle. The electric vehicle includes a vehicle frame, a power battery, and the power supply apparatus according to the second aspect. The vehicle frame is configured to fasten the power battery and the power supply apparatus, the bus capacitor in the motor controller integrated module of the power supply apparatus is configured to electrically connect to the power battery, and the power battery is configured to drive, by using a motor, a wheel of the electric vehicle to travel.

In embodiments of this application, the motor controller integrated module in the power supply apparatus is arranged in a manner in which the bus capacitor and the two power assemblies are stacked in the width direction of the capacitor core package, so that the motor controller integrated module has a relatively small size in the length direction of the capacitor core package and in the width direction of the capacitor core package. In this way, an overall size of the motor controller integrated module is relatively small, and a size of the power supply apparatus is relatively small. This helps optimize a layout of the power supply apparatus in the entire vehicle.

### BRIEF DESCRIPTION OF DRAWINGS

To describe technical solutions in embodiments of this application more clearly, the following describes the accompanying drawings used in embodiments of this application.
FIG. 1 is a diagram of a structure of an electric vehicle according to an embodiment of this application;
FIG. 2 is a diagram of a structure of a powertrain according to an embodiment of this application;
FIG. 3 is a diagram of a structure of a power supply apparatus according to an embodiment of this application;
FIG. 4 is a diagram of a structure of a motor controller integrated module according to an embodiment of this application;
FIG. 5 is an exploded view of the motor controller integrated module in FIG. 4;
FIG. 6 is another diagram of a structure of a motor controller integrated module according to an embodiment of this application;
FIG. 7 is another diagram of a structure of a motor controller integrated module according to an embodiment of this application;
FIG. 8 is an exploded view of a heat sink and a power assembly of the motor controller integrated module in FIG. 7;
FIG. 9 is a diagram of a structure of a housing according to an embodiment of this application;
FIG. 10 is a diagram of a structure of a power module according to an embodiment of this application;
FIG. 11 is an exploded view of two input connection copper sheets and an insulating separator according to an embodiment of this application; and
FIG. 12 is another diagram of a structure of a motor controller integrated module according to an embodiment of this application.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

For ease of understanding, English abbreviations and related technical terms used in embodiments of this application are first explained and described below.

EMC: is an abbreviation of electromagnetic compatibility. The EMC refers to a capability of electronic products or electrical devices to work normally according to a design requirement in a specified electromagnetic environment.

Perpendicular: "Perpendicular" defined in embodiments of this application is not limited to an absolute perpendicular intersection (where an included angle is 90 degrees) relationship. A perpendicular intersection relationship that is not absolute due to an assembly tolerance, a design tolerance, impact of structural flatness, or another factor is allowed. An error within a small angle range is allowed. For example, a relationship within an assembly error range of 80 degrees to 100 degrees may be understood as a perpendicular relationship.

Parallel: "Parallel" defined in embodiments of this application is not limited to absolute parallelism. The definition of parallelism herein may be understood as basic parallelism. Parallelism that is not absolute due to an assembly tolerance, a design tolerance, impact of structural flatness, or another factor is allowed.

A width direction of a capacitor core package is denoted as Y, a length direction of the capacitor core package is denoted as X, and an arrangement direction of a groove bottom and a groove opening of an accommodating groove is denoted as Z. The directions X, Y, and Z are perpendicular to each other.

To reduce a size of a power supply apparatus and optimize a layout of an entire vehicle, this application provides a motor controller integrated module. A bus capacitor, a heat sink, and two power assemblies are integrated into the motor controller integrated module, the bus capacitor includes a housing and a capacitor core package, the housing is configured to fasten the heat sink and the two power assemblies, each power assembly is configured to implement mutual conversion between a direct current and a three-phase alternating current, the capacitor core package is configured to electrically connect to an end that is of each power assembly and that transmits the direct current, and the heat sink is configured to cool the two power assemblies. The housing includes an accommodating groove, the accommodating groove is configured to accommodate the capacitor core package, a length of the capacitor core package in a width direction of the capacitor core package is less than a length of the capacitor core package in a length direction of the capacitor core package, a peripheral groove wall of the accommodating groove includes two first side walls, and the two first side walls are opposite to each other in the width direction of the capacitor core package. The heat sink includes a heat dissipation plate. In the width direction of the capacitor core package, the two power assemblies and the heat dissipation plate are stacked and arranged on a side that is of one first side wall and that is away from the other first side wall. Each power assembly includes three power modules, the three power modules are sequentially arranged and spaced apart in the length direction of the capacitor core package, and a thickness direction of each power module is parallel to the width direction of the capacitor core package. In an arrangement manner in which the bus capacitor and the two power assemblies are stacked in the width direction of the capacitor core package, the motor controller integrated module has a relatively small size in the length direction of the capacitor core package, and also has a relatively small size in the width direction of the capacitor core package. This helps reduce an overall size of the motor controller integrated module, and further reduce the size of the power supply apparatus, thereby helping optimize the layout of the entire vehicle.

The motor controller integrated module provided in embodiments of this application is used in a power supply apparatus, and the power supply apparatus is used in an electric vehicle, to improve overall performance of the electric vehicle.

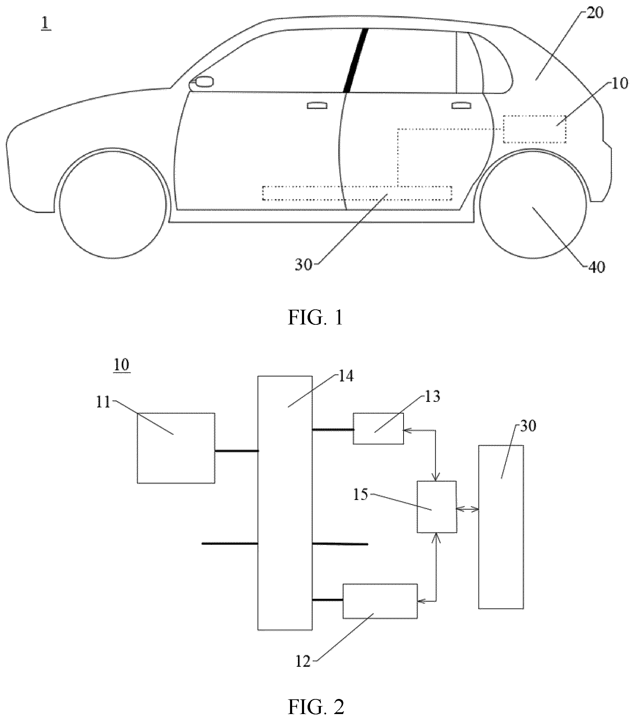

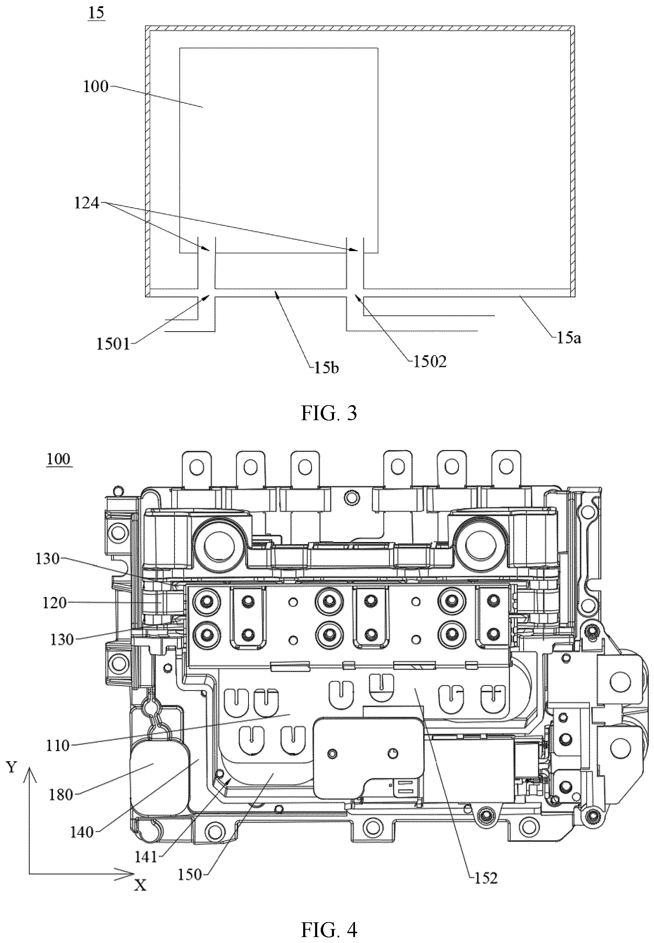

FIG. 1 is a diagram of a structure of an electric vehicle 1 according to an embodiment of this application. FIG. 2 is a diagram of a structure of a powertrain 10 according to an embodiment of this application. FIG. 3 is a diagram of a structure of a power supply apparatus 15 according to an embodiment of this application.

In an embodiment, the electric vehicle 1 includes a vehicle frame 20, a power battery 30, and the powertrain 10. As shown in FIG. 1, the vehicle frame 20 is configured to fasten the power battery 30 and the powertrain 10. In embodiments of this application, the electric vehicle 1 is a wheeled device driven or pulled by a power apparatus. In embodiments of this application, the powertrain 10 is configured to receive power supplied by the power battery 30, and is configured to drive a wheel 40.

In an embodiment, the powertrain 10 includes an engine 11, a motor 12, a generator 13, a reducer 14, and the power supply apparatus 15. As shown in FIG. 1 and FIG. 2, the engine 11 is configured to output power. For example, the engine 11 may be a fuel engine, and the fuel engine includes a gasoline engine or a diesel engine. The generator 13 is in transmission connection to the engine 11, the engine 11 provides power for the generator 13, and the generator 13 converts kinetic energy output by the engine 11 into electric energy. The generator 13 is electrically connected to the power battery 30, and the generator 13 may charge the power battery 30 through the power supply apparatus 15. The motor 12 is electrically connected to the power battery 30, and the power battery 30 may supply power to the motor 12 through the power supply apparatus 15. The motor 12 is configured to convert electric energy output by the power battery 30 into kinetic energy. The motor 12, the generator 13, and the motor 12 are in transmission connection to the wheel 40 through the reducer 14, to provide power for the wheel 40 to drive the wheel 40 to move. In an embodiment, the engine 11 provides power for the generator 13, and the generator 13 directly transmits the power to the wheel 40 to drive the wheel 40 to run, thereby implementing dual-motor driving.

In embodiments of this application, the power supply apparatus 15 is configured to charge and discharge the power battery 30 and drive the motor 12. The power supply apparatus 15 is configured to receive a high-voltage direct current transmitted by the power battery 30, convert the high-voltage direct current into a high-voltage alternating current, and transmit the high-voltage alternating current to the motor 12, to drive the motor 12 to rotate. In an embodiment, the power supply apparatus 15 is configured to receive an alternating current and convert the alternating current into a direct current to charge the power battery 30. The alternating current includes mains electricity or a civil alternating current. In an embodiment, the power supply apparatus 15 receives a high-voltage direct current and provides the direct current for the power battery 30 for charging.

In an embodiment, the power supply apparatus 15 includes a motor controller integrated module 100 and at least one of an in-vehicle charger (not shown in the figure), a power distribution module (not shown in the figure), and a vehicle controller (not shown in the figure).

The motor controller integrated module 100 is configured to receive a high-voltage direct current of the power battery 30, convert the high-voltage direct current into a high-voltage alternating current, and transmit the high-voltage alternating current to a winding (not shown in the figure) of the motor 12, to drive a rotor and a motor shaft of the motor 12 to rotate. The motor controller integrated module 100 may further receive an induced current generated by the generator 13, to charge the power battery 30.

In an embodiment, a bottom plate 15a of the power supply apparatus 15 includes a liquid inlet hole 1501 and a liquid outlet hole 1502. As shown in FIG. 3, the liquid inlet hole 1501 and the liquid outlet hole 1502 communicate with a heat sink (not shown in the figure) of the motor controller integrated module 100, so that an internal flow channel 15b of a housing of the power supply apparatus 15 communicates with an internal flow channel of the heat sink of the motor controller integrated module 100, to cool the motor controller integrated module 100.

The powertrain 10 of the hybrid electric vehicle 1 includes the generator 13 and the motor 12. Two power assemblies need to be arranged in the motor controller integrated module 100 to implement current conversion with the generator 13 and the motor 12 respectively. Consequently, a size of the motor controller integrated module 100 is increased, and an overall size of the power supply apparatus 15 is increased. This is non-conducive to a layout of the power supply apparatus 15 in the entire vehicle.

In embodiments of this application, the motor controller integrated module is improved, so that a layout of electrical components in the motor controller integrated module is more compact and occupies a small size, and an overall size of the motor controller integrated module is reduced. Therefore, the overall size of the power supply apparatus 15 is reduced, and an entire vehicle layout is optimized.

The following describes in detail the motor controller integrated module 100 provided in embodiments of this application.

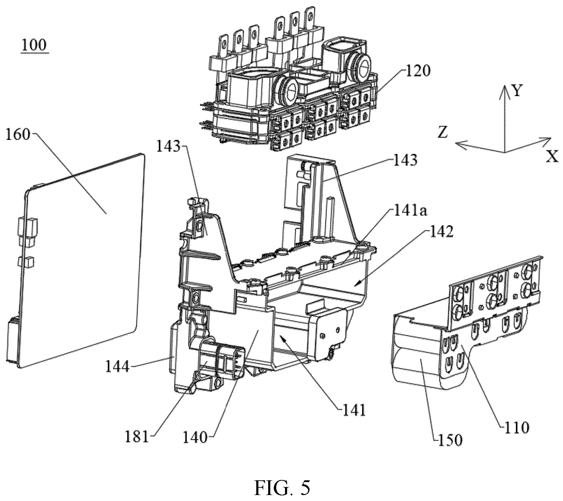

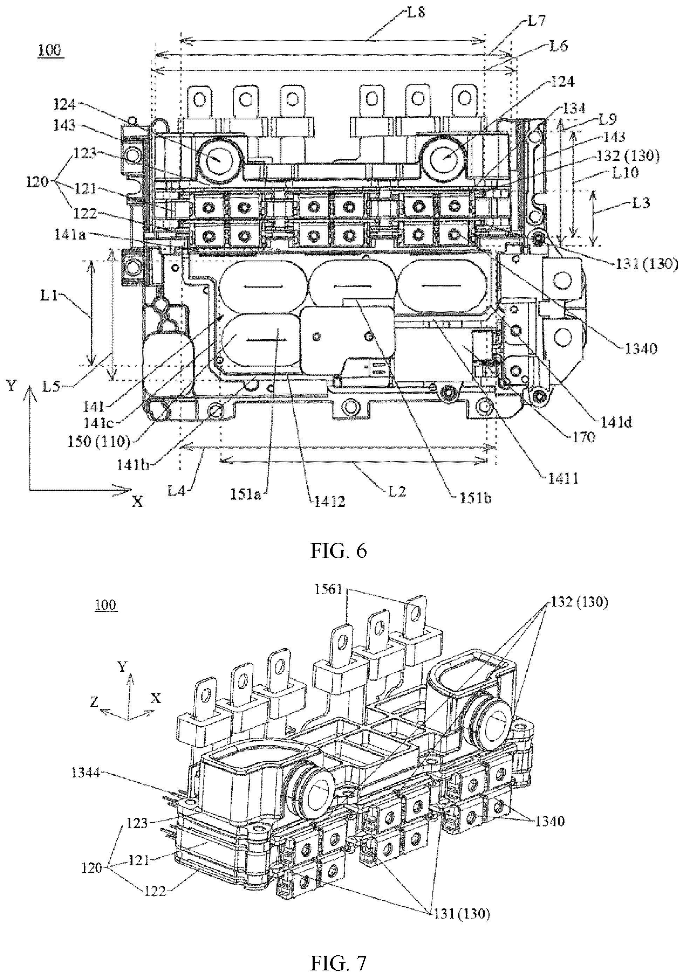

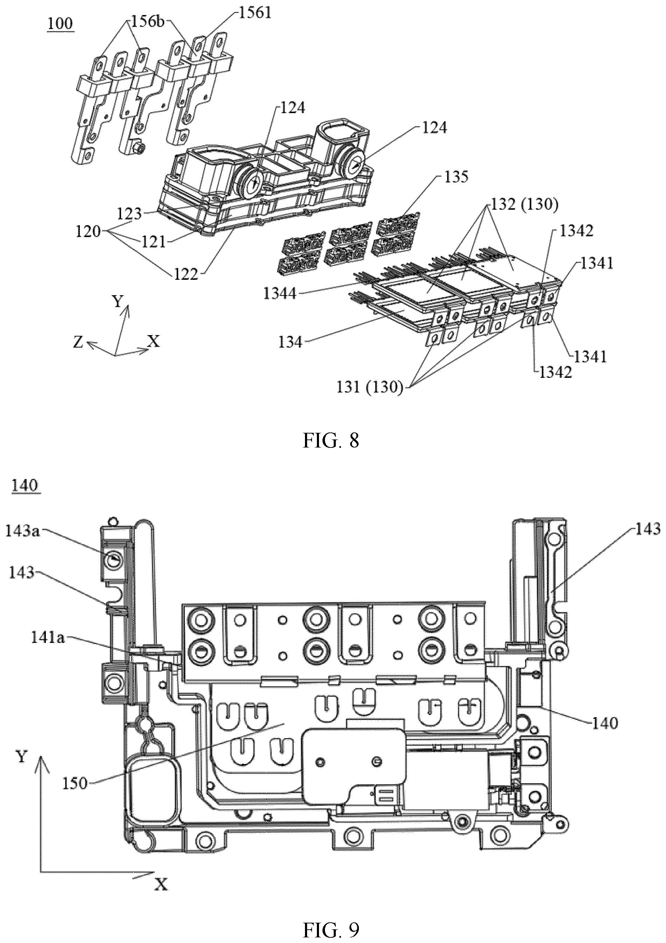

FIG. 4 is a diagram of a structure of a motor controller integrated module 100 according to an embodiment of this application. FIG. 5 is an exploded view of the motor controller integrated module 100 in FIG. 4. FIG. 6 is another diagram of a structure of a motor controller integrated module 100 according to an embodiment of this application. FIG. 7 is another diagram of a structure of a motor controller integrated module 100 according to an embodiment of this application. FIG. 8 is an exploded view of a heat sink 120 and a power assembly 130 of the motor controller integrated module 100 in FIG. 7.

In an embodiment, a bus capacitor 110, a heat sink 120, and two power assemblies 130 are integrated into the motor controller integrated module 100. As shown in FIG. 5 and FIG. 8, the bus capacitor 110 includes a housing 140 and a capacitor core package 150, the housing 140 is configured to fasten the heat sink 120 and the two power assemblies 130, each power assembly 130 is configured to implement mutual conversion between a direct current and a three-phase alternating current, the capacitor core package 150 is configured to electrically connect to an end that is of each power assembly 130 and that transmits the direct current, the capacitor core package 150 is configured to output a direct current to at least one power assembly 130 or receive a direct current output by at least one power assembly 130, and the heat sink 120 is configured to cool the two power assemblies 130.

In embodiments of this application, the bus capacitor 110 may provide a ripple current when the power supply apparatus 15 drives the motor, to reduce a bus current fluctuation of the entire vehicle, thereby reducing a bus voltage ripple of the entire vehicle. The housing 140 provides space for mounting and fastening the heat sink 120 and the two power assemblies 130.

One power assembly 130 is configured to convert a direct current into a three-phase alternating current, or one power assembly 130 is configured to convert a three-phase alternating current into a direct current. The two power assemblies 130 may implement conversion in a same direction or conversion in opposite directions.

In an embodiment, the capacitor core package 150 is configured to output a direct current to at least one power assembly 130, and the at least one power assembly 130 is configured to receive the direct current output by the capacitor core package 150, convert the direct current into a three-phase alternating current, and transmit the three-phase alternating current to a winding of the motor 12 (as shown in FIG. 2), to drive the motor 12 to operate.

In an embodiment, the capacitor core package 150 is configured to receive a direct current output by one power assembly 130. The generator 13 receives power provided by the engine 11, and drives a rotor of the generator 13 to rotate to cut a magnetic induction line, so that the winding generates an induced current. The current is converted into a direct current by using the power assembly 130, and the direct current is transmitted to the power battery 30 through the capacitor core package 150 for charging.

In an embodiment, when the generator 13 is used as a drive motor, the two power assemblies 130 are configured to receive a direct current through the capacitor core package 150, convert the direct current into two three-phase alternating currents, and transmit the two three-phase alternating currents to the generator 13 and the motor 12 respectively.

The heat sink 120 is configured to cool the two power assemblies 130. This helps dissipate heat of the two power assemblies 130 in a timely manner, and ensure normal operation of the motor controller integrated module 100.

In an embodiment, the bus capacitor 110 and the two power assemblies 130 may be connected through laser welding or screw locking.

In an embodiment, the housing 140 includes an accommodating groove 141. As shown in FIG. 4 and FIG. 5, the accommodating groove 141 is configured to accommodate the capacitor core package 150. As shown in FIG. 6, a length of the capacitor core package 150 in a width direction Y of the capacitor core package 150 is less than a length of the capacitor core package 150 in a length direction X of the capacitor core package 150. A peripheral groove wall of the accommodating groove 141 includes two first side walls 141a and 141b, and the two first side walls 141a and 141b are opposite to each other in the width direction Y of the capacitor core package 150. The heat sink 120 includes a heat dissipation plate 121. As shown in FIG. 6 and FIG. 7, in the width direction Y of the capacitor core package 150, the two power assemblies 130 and the heat dissipation plate 121 are stacked and arranged on a side that is of the first side wall 141a and that is away from the other first side wall 141b. Each power assembly 130 includes three power modules 134. As shown in FIG. 8, the three power modules 134 are sequentially arranged and spaced apart in the length direction X of the capacitor core package 150, and a thickness direction of each power module 134 is parallel to the width direction Y of the capacitor core package 150.

In embodiments of this application, the length of the capacitor core package 150 in the width direction Y of the capacitor core package 150 is denoted as L1, and the length of the capacitor core package 150 in the length direction X of the capacitor core package 150 is denoted as L2. As shown in FIG. 6, L1<L2. This helps reduce space in the motor controller integrated module 100 occupied by the capacitor core package 150 in the width direction Y of the capacitor core package 150, and helps reduce an overall size of the motor controller integrated module 100. The peripheral groove wall of the accommodating groove 141 includes the two first side walls 141a and 141b, the two first side walls 141a and 141b are opposite to each other in the width direction Y of the capacitor core package 150, and the capacitor core package 150 is accommodated between the two first side walls 141a and 141b, so that the length of the capacitor core package 150 in the width direction Y of the capacitor core package 150 does not exceed a distance between the two first side walls 141a and 141b, and space occupied by the capacitor core package 150 in the width direction Y of the capacitor core package 150 is relatively small. In this way, the two first side walls 141a and 141b can further reduce electrical interference caused by another electrical component in the motor controller integrated module 100 on the capacitor core package 150 in the width direction Y of the capacitor core package 150, thereby facilitating normal operation of the electrical component in the motor controller integrated module 100.

In embodiments of this application, the heat sink 120 includes the heat dissipation plate 121. As shown in FIG. 6 and FIG. 8, the heat dissipation plate 121 is used for flowing of coolant, to dissipate heat for the two power assemblies 130. In the width direction Y of the capacitor core package 150, the two power assemblies 130 and the heat dissipation plate 121 are stacked and arranged on the side that is of the first side wall 141a and that is away from the other first side wall 141b, so that the two power assemblies 130 and the heat dissipation plate 121 are more compactly arranged on the first side wall 141a. The two power assemblies 130 and the heat dissipation plate 121 are arranged on a side that is of the capacitor core package 150 and that has a larger length, so that the two power assemblies 130 and the heat dissipation plate 121 do not occupy excessive space of the motor controller integrated module 100 in the length direction X of the capacitor core package 150. This helps improve integration of the motor controller integrated module 100, so that the motor controller integrated module 100 is miniaturized, an overall size of the motor controller integrated module 100 is reduced, and a layout in the entire vehicle is optimized. If the two power assemblies 130 and the bus capacitor 110 are disposed in a flat manner in the length direction X of the capacitor core package 150 or the width direction Y of the capacitor core package 150, an overall size of the motor controller integrated module 100 is relatively large. This is not conducive to a decrease in the size of the motor controller integrated module 100 and is not conducive to a miniaturization layout of the power supply apparatus 15 in the electric vehicle 1.

In embodiments of this application, as shown in FIG. 7 and FIG. 8, the heat dissipation plate 121 and the two power assemblies 130 are arranged in a stacked manner, so that heat generated by the two power assemblies 130 can be more quickly absorbed by the heat dissipation plate 121 through a short path, and there may further be a relatively large heat dissipation contact area. This helps the heat dissipation plate 121 dissipate heat for the two power assemblies 130 at the same time.

In embodiments of this application, each power assembly 130 includes three power modules 134. As shown in FIG. 8, the three power modules 134 are sequentially arranged and spaced apart in the length direction X of the capacitor core package 150, the three power modules 134 are stacked on the capacitor core package 150 in the width direction Y of the capacitor core package 150, a thickness direction of each power module 134 is parallel to the width direction Y of the capacitor core package 150, and a length of each power module 134 in the thickness direction is relatively small. The thickness direction of each power module 134 is parallel to the width direction Y of the capacitor core package 150, so that each power module 134 does not occupy excessive space of the motor controller integrated module 100 in the width direction Y of the capacitor core package 150.

In embodiments of this application, in the motor controller integrated module 100, the length of the capacitor core package 150 in the width direction Y of the capacitor core package 150 is set to be relatively small, so that the capacitor core package 150 occupies relatively small space of the motor controller integrated module 100 in the width direction Y of the capacitor core package 150, and space of the capacitor core package 150 in the width direction Y of the capacitor core package 150 can be reserved for arranging the heat sink 120 and the power assembly 130. The two power assemblies 130 and the heat dissipation plate 121 are stacked and arranged on an outer side of the accommodating groove 141 in the width direction Y, and the thickness direction of each power module 134 is parallel to the width direction Y of the capacitor core package 150, so that the two power assemblies 130 and the heat dissipation plate 121 are more compactly arranged on a side of the capacitor core package 150 in the width direction Y of the capacitor core package 150. In this way, the two power assemblies 130 and the heat dissipation plate 121 do not occupy excessive space of the motor controller integrated module 100 in the length direction X of the capacitor core package 150, so that the motor controller integrated module 100 has a relatively small size in both the width direction Y of the capacitor core package 150 and the length direction X of the capacitor core package 150. Therefore, an overall size of the motor controller integrated module 100 is small, and a size of the power supply apparatus 15 is small. This facilitates a layout of the power supply apparatus 15 in the entire vehicle.

In an embodiment, there is an insulating adhesive layer (not shown in the figure) at a groove opening 142 of the accommodating groove 141, so that the capacitor core package 150 is fastened in the accommodating groove 141. This facilitates electrical connection stability, and further helps protect the capacitor core package 150 from electrical interference caused by an electrical component in space in an arrangement direction Z of a groove bottom 144 and the groove opening 142 of the accommodating groove 141.

In an embodiment, the length of the capacitor core package 150 in the length direction X of the capacitor core package 150 is greater than a sum of lengths of the two power assemblies 130 and the heat dissipation plate 121 in the width direction Y of the capacitor core package 150.

As shown in FIG. 6, in embodiments of this application, the length of the capacitor core package 150 in the length direction X of the capacitor core package 150 is L2, the sum of the lengths of the two power assemblies 130 and the heat dissipation plate 121 in the width direction Y of the capacitor core package 150 is denoted as L3, and L2>L3, so that although the two power assemblies 130 and the heat dissipation plate 121 are stacked and arranged on the first side wall 141a in the width direction Y of the capacitor core package 150, space of the motor controller integrated module 100 in the width direction Y of the capacitor core package 150 is not occupied excessively. This helps avoid a large overall size of the motor controller integrated module 100 when the two power assemblies 130, the heat dissipation plate 121, and the capacitor core package 150 are integrated, and is conducive to a miniaturization layout of the motor controller integrated module 100.

In an embodiment, a length of the first side wall 141a in the length direction X of the capacitor core package 150 is greater than a distance between the two first side walls 141a and 141b in the width direction Y of the capacitor core package 150, and the length of the first side wall 141a in the length direction X of the capacitor core package 150 is greater than the sum of the lengths of the two power assemblies 130 and the heat dissipation plate 121 in the width direction Y of the capacitor core package 150.

As shown in FIG. 6, in embodiments of this application, the length of the first side wall 141a in the length direction X of the capacitor core package 150 is denoted as L4, the distance between the two first side walls 141a and 141b in the width direction Y of the capacitor core package 150 is denoted as L5, and L4>L5. Space occupied by the two first side walls 141a and 141b of the accommodating groove 141 in the width direction Y of the capacitor core package 150 is very small. This helps the capacitor core package 150 between the two first side walls 141a and 141b have a small size in the width direction Y of the capacitor core package 150.

In embodiments of this application, the length of the first side wall 141a in the length direction X of the capacitor core package 150 is L4, the sum of the lengths of the two power assemblies 130 and the heat dissipation plate 121 in the width direction Y of the capacitor core package 150 is L3, and L4>L3. Space occupied by the two power assemblies 130 and the heat dissipation plate 121 in the width direction Y of the capacitor core package 150 is relatively small. This facilitates miniaturization of the motor controller integrated module 100 in the width direction Y of the capacitor core package 150.

In an embodiment, the capacitor core package 150, the first side wall 141a, one power assembly 131, the heat dissipation plate 121, and the other power assembly 132 are sequentially arranged in the width direction Y of the capacitor core package 150.

As shown in FIG. 6 and FIG. 8, in embodiments of this application, in the width direction Y of the capacitor core package 150, the heat dissipation plate 121 is arranged between the power assembly 131 and the other power assembly 132, so that the heat dissipation plate 121 can simultaneously dissipate heat for the two power assemblies 130, and heat generated by the two power assemblies 130 can be absorbed by the heat dissipation plate 121 through a short path, thereby helping improve efficiency of cooling the two power assemblies 130 by the heat dissipation plate 121. A stacking arrangement of the heat dissipation plate 121, the power assembly 131, and the other power assembly 132 also helps make the heat dissipation plate 121 have a relatively large heat dissipation contact area with each of the two power assemblies 130, and helps quickly take away heat generated by the two power assemblies 130 when the coolant passing through the heat dissipation plate 121 flows through the heat dissipation plate 121, thereby helping ensure normal operation of the two power assemblies 130.

In embodiments of this application, the capacitor core package 150, the first side wall 141a, the power assembly 131, the heat dissipation plate 121, and the other power assembly 132 are sequentially arranged in the width direction Y of the capacitor core package 150, so that the capacitor core package 150, the power assembly 131, the heat dissipation plate 121, and the other power assembly 132 do not occupy excessive space of the motor controller integrated module 100 in the length direction X of the capacitor core package 150. In this way, the motor controller integrated module 100 has a small size in the length direction X of the capacitor core package 150. In addition, an overall length of the capacitor core package 150, the first side wall 141a, the power assembly 131, the heat dissipation plate 121, and the other power assembly 132 is also relatively small in the width direction Y of the capacitor core package 150, so that an overall size of the motor controller integrated module 100 is relatively small. This facilitates a miniaturization layout of the motor controller integrated module 100 in the power supply apparatus 15, thereby optimizing an entire vehicle layout.

In an embodiment, the heat sink 120 further includes another heat dissipation plate 122. As shown in FIG. 6 and FIG. 8, the capacitor core package 150, the first side wall 141a, the another heat dissipation plate 122, the power assembly 131, the heat dissipation plate 121, and the other power assembly 132 are sequentially arranged in the width direction Y of the capacitor core package 150.

In embodiments of this application, the capacitor core package 150, the first side wall 141a, the another heat dissipation plate 122, the power assembly 131, the heat dissipation plate 121, and the other power assembly 132 are sequentially arranged in the width direction Y of the capacitor core package 150, and the two heat dissipation plates 121 and 122 and the two power assemblies 130 are alternately stacked, thereby increasing a heat dissipation area between the two heat dissipation plates 121 and 122 and the two power assemblies 130. This accelerates absorption of the two heat dissipation plates 121 and 122 for heat generated by the two power assemblies 130, and helps improve effect of cooling the two power assemblies 130 by the heat sink 120.

In an embodiment, the heat sink 120 further includes a bottom plate 123. As shown in FIG. 6 and FIG. 8, the bottom plate 123 includes two holes 124, and the two holes 124 are used to communicate with an internal flow channel of the heat dissipation plate 121 through an internal flow channel of the bottom plate 123. In the width direction Y of the capacitor core package 150, the bottom plate 123 is arranged on a side that is of the two power assemblies 130 and the heat dissipation plate 121 and that is away from the capacitor core package 150. Orientations of openings of the two holes 124 are the same as an orientation of the groove opening 142 of the accommodating groove 141.

In embodiments of this application, the bottom plate 123 includes the two holes 124, and the two holes 124 are used to receive coolant from an external cooling circulation system and output coolant that absorbs heat and heats up in the heat sink 120. The two holes 124 are used to communicate with the internal flow channel of the heat dissipation plate 121 through the internal flow channel of the bottom plate 123. The internal flow channels of the heat dissipation plate 121 and the bottom plate 123 communicate through the two holes 124, so that the coolant in the heat sink 120 can flow smoothly. The bottom plate 123 may also cool a power assembly 130 adjacent to the bottom plate 123.

In embodiments of this application, in the width direction Y of the capacitor core package 150, the bottom plate 123 is arranged on the side that is of the two power assemblies 130 and the heat dissipation plate 121 and that is away from the capacitor core package 150, so that the bottom plate 123 can directly cool the other power assembly 132 in the two power assemblies 130. Compared with arranging the bottom plate 123 on a side that is of the two power assemblies 130 and the heat dissipation plate 121 and that is close to the capacitor core package 150, arranging the bottom plate 123 on the side that is of the two power assemblies 130 and the heat dissipation plate 121 and that is away from the capacitor core package 150 helps shorten a distance of an electrical connection between the capacitor core package 150 and the two power assemblies 130, and also helps implement a copper bar electrical connection between the capacitor core package 150 and the two power assemblies 130.

In embodiments of this application, the orientations of the openings of the two holes 124 are the same as the orientation of the groove opening 142 of the accommodating groove 141, so that the two holes 124 on the bottom plate 123 can communicate with an internal flow channel 15b (as shown in FIG. 3) of the housing of the power supply apparatus 15, thereby improving integration of the motor controller integrated module 100 in the power supply apparatus 15.

FIG. 9 is a diagram of a structure of a housing 140 according to an embodiment of this application.

In an embodiment, the housing 140 further includes two fastening protrusions 143. As shown in FIG. 9, the two fastening protrusions 143 are configured to fasten an electrical component. As shown in FIG. 5, the two fastening protrusions 143 protrude from the first side wall 141a away from the capacitor core package 150 in the width direction Y of the capacitor core package 150, and space between the two fastening protrusions 143 is used to accommodate the heat sink 120 and the two power assemblies 130. As shown in FIG. 6, in the length direction X of the capacitor core package 150, a distance between the two fastening protrusions 143 is greater than a length of the heat sink 120 or each power assembly 130. In the width direction Y of the capacitor core package 150, a length of each fastening protrusion 143 is greater than a sum of lengths of the heat sink 120 and the two power assemblies 130.

In embodiments of this application, the two fastening protrusions 143 protrude from the first side wall 141a away from the capacitor core package 150 in the width direction Y of the capacitor core package 150, so that the heat sink 120 that is stacked in the width direction Y of the capacitor core package 150 and arranged on a side that is of the first side wall 141a and that is away from the other first side wall 141b can be fastened to the two fastening protrusions 143. This is conducive to stability of an overall structure of the motor controller integrated module 100. Space between the two fastening protrusions 143 is used to accommodate the heat sink 120 and the two power assemblies 130, so that the two fastening protrusions 143 of the housing 140 are more highly integrated with the heat sink 120 and the two power assemblies 130, and a size of the heat sink 120 and the two power assemblies 130 is not excessively large in the length direction X of the capacitor core package 150. This facilitates miniaturization of the motor controller integrated module 100.

As shown in FIG. 9, the two fastening protrusions 143 may further fasten an electrical component by using fastening through holes 143a on two sides. For example, the two fastening protrusions 143 fasten a Hall copper bar component (not shown in the figure) by using the fastening through holes 143a on the two sides. This helps improve integration of the power supply apparatus 15.

As shown in FIG. 6, in embodiments of this application, in the length direction X of the capacitor core package 150, the distance between the two fastening protrusions 143 is denoted as L6, the length of the heat sink 120 is denoted as L7, the length of each power assembly 130 is denoted as L8, L6>L7, and L6>L8. Arrangement space of the heat sink 120 and the two power assemblies 130 in the length direction X of the capacitor core package 150 is relatively small. In this way, a size of the motor controller integrated module 100 is relatively small in the length direction X of the capacitor core package 150. This is conducive to miniaturization of the motor controller integrated module 100.

As shown in FIG. 6, in embodiments of this application, in the width direction Y of the capacitor core package 150, the length of each fastening protrusion 143 is denoted as L9, the sum of the lengths of the heat sink 120 and the two power assemblies 130 is denoted as L10, and L9>L10. In this way, the heat sink 120 and the two power assemblies 130 are all disposed in the housing 140 of the motor controller integrated module 100 in the width direction Y of the capacitor core package 150, and do not occupy excessive space outside the housing 140. This facilitates small-size arrangement of the motor controller integrated module 100 in the width direction Y of the capacitor core package 150.

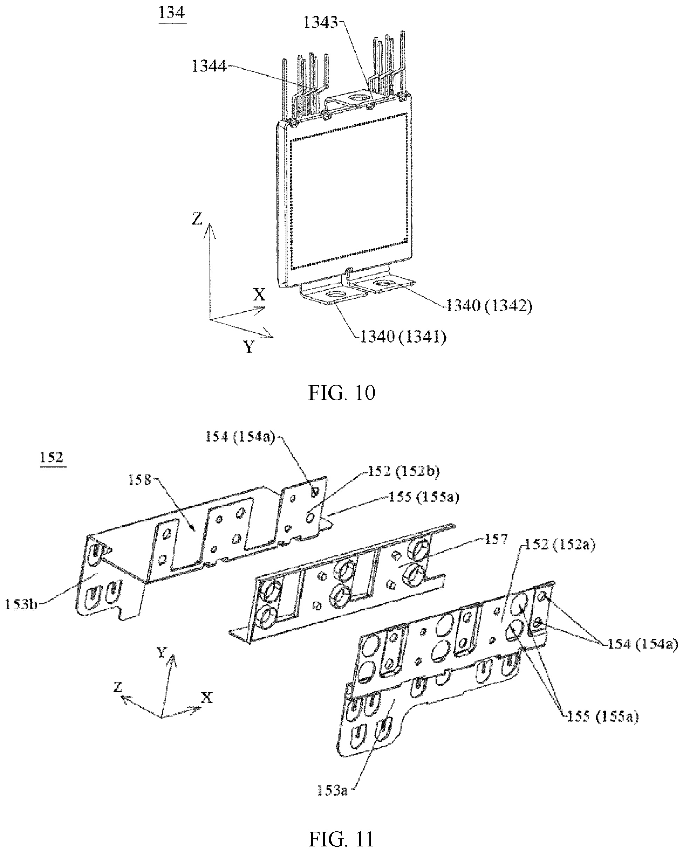

FIG. 10 is a diagram of a structure of a power module 134 according to an embodiment of this application.

In an embodiment, each power module 134 includes two input copper bars 1340 and an output copper bar 1343. As shown in FIG. 6 and FIG. 10, the two input copper bars 1340 are configured to be electrically connected to the capacitor core package 150 to receive a direct current, and the output copper bar 1343 is configured to output a one-phase alternating current. The two input copper bars 1340 are arranged opposite to the output copper bar 1343 in the arrangement direction Z of the groove bottom 144 and the groove opening 142 of the accommodating groove 141. As shown in FIG. 6, the two input copper bars 1340 are on a same side as the groove opening 142 of the accommodating groove 141, and the two input copper bars 1340 of each power module 134 are arranged and spaced apart in the length direction X of the capacitor core package 150. As shown in FIG. 6 and FIG. 8, each input copper bar 1340 is bent toward the first side wall 141a in the width direction Y of the capacitor core package 150.

In embodiments of this application, each power module 134 includes two input copper bars 1340 and an output copper bar 1343. The two input copper bars 1340 are configured to be electrically connected to the capacitor core package 150 to receive a direct current, and the output copper bar 1343 is configured to output a one-phase alternating current. Each power assembly 130 includes three power modules 134. The three power modules 134 are configured to receive a direct current output by the capacitor core package 150, and are configured to convert the direct current into a three-phase alternating current, and then transmit the three-phase alternating current to the winding of the motor 12, to drive the motor 12 to operate. Alternatively, the three power modules 134 convert a three-phase alternating current output by the generator 13 into a direct current, and charge the power battery 30 through the capacitor core package 150.

In embodiments of this application, in the arrangement direction Z of the groove bottom 144 and the groove opening 142 of the accommodating groove 141, the two input copper bars 1340 are arranged opposite to the output copper bar 1343, so that a current in each power module 134 may be transmitted in the arrangement direction Z of the groove bottom 144 and the groove opening 142 of the accommodating groove 141. The two input copper bars 1340 are on the same side as the groove opening 142 of the accommodating groove 141. This facilitates direct current transmission between the two input copper bars 1340 of each power module 134 and the capacitor core package 150. The two input copper bars 1340 of each power module 134 are arranged and spaced apart in the length direction X of the capacitor core package 150, to avoid electrical connection interference between the two input copper bars 1340 of each power module 134. Each input copper bar 1340 is bent toward the first side wall 141a in the width direction Y of the capacitor core package 150, so that each input copper bar 1340 is electrically connected to the capacitor core package 150 on the other side of the first side wall 141a, and each power module 134 does not occupy excessive space of the motor controller integrated module in the arrangement direction Z of the groove bottom 144 and the groove opening 142 of the accommodating groove 141.

FIG. 11 is an exploded view of two input connection copper sheets 152 and an insulating separator 157 according to an embodiment of this application.

In an embodiment, the bus capacitor 110 further includes two input connection copper sheets 152. As shown in FIG. 4, FIG. 10, and FIG. 11, one input connection copper sheet 152a is configured to electrically connect a positive electrode of the capacitor core package 150 and the input copper bar 1341 of each power module 134, and the other input connection copper sheet 152b is configured to electrically connect a negative electrode of the capacitor core package 150 and the other input copper bar 1342 of each power module 134. In the arrangement direction Z of the groove bottom 144 and the groove opening 142 of the accommodating groove 141, the two input connection copper sheets 152 are stacked and spaced apart in an insulating manner. In the arrangement direction Z of the groove bottom 144 and the groove opening 142 of the accommodating groove 141, the two input connection copper sheets 152 are stacked on the two input copper bars 1340 of each power module 134.

In embodiments of this application, the input connection copper sheet 152a is configured to electrically connect the positive electrode of the capacitor core package 150 and the input copper bar 1341 of each power module 134, the input copper bar 1341 is a positive electrode of each power module 134, the other input connection copper sheet 152b is configured to electrically connect the negative electrode of the capacitor core package 150 and the other input copper bar 1342 of each power module 134, and the other input copper bar 1342 is a negative electrode of each power module 134. The two input connection copper sheets 152 of the bus capacitor 110 electrically connect the positive and negative electrodes of the capacitor core package 150 to the positive and negative electrodes of each power module 134 respectively, so that a direct current of the capacitor core package 150 can be input to the power module 134, and each power module 134 can output a one-phase alternating current to the winding of the motor 12 through the output copper bar 1343. The two input connection copper sheets 152 of the bus capacitor 110 electrically connect the positive and negative electrodes of the capacitor core package 150 to the positive and negative electrodes of the power module 134 respectively, so that the power module 134 can further output a direct current to charge the power battery.

In embodiments of this application, in the arrangement direction Z of the groove bottom 144 and the groove opening 142 of the accommodating groove 141, the two input connection copper sheets 152 are stacked and spaced apart in an insulating manner, and the two input connection copper sheets 152 are stacked. The input connection copper sheet 152a is connected to the positive electrode of the capacitor core package 150, and the other input connection copper sheet 152b is connected to the negative electrode of the capacitor core package 150, so that current directions of the two input connection copper sheets 152 are opposite. When the two input connection copper sheets 152 are stacked, magnetic fields generated by the two input connection copper sheets 152 in opposite current directions may partially offset each other, thereby reducing stray inductance generated by the two input connection copper sheets 152, so that the bus capacitor 110 is applicable to application of the motor controller integrated module 100.

In an embodiment, insulating separation between the two input connection copper sheets 152 may be implemented by inserting an insulating separator 157 between the two input connection copper sheets 152. Alternatively, insulating material injection molding or insulating gel sealing is performed between the two input connection copper sheets 152, to implement insulating separation between the two input connection copper sheets 152.

In embodiments of this application, in the arrangement direction Z of the groove bottom 144 and the groove opening 142 of the accommodating groove 141, the two input connection copper sheets 152 are stacked on the two input copper bars 1340 of each power module 134, so that the two input connection copper sheets 152 can be electrically connected to the two input copper bars 1340 of each power module 134. The stacking arrangement manner further helps make an electrical connection more stable, improve integration of the motor controller integrated module 100, and reduce a size occupied due to tiling. This facilitates miniaturization of the motor controller integrated module 100.

In an embodiment, the bus capacitor 110 further includes two other input connection copper sheets 153a and 153b. As shown in FIG. 10 and FIG. 11, the two input connection copper sheets 152 are electrically connected to a positive electrode and a negative electrode of the bus capacitor 110 through the two other input connection copper sheets 153a and 153b, and in the arrangement direction Z of the groove bottom 144 and the groove opening 142 of the accommodating groove 141, the capacitor core package 150 is stacked between the two other input connection copper sheets 153a and 153b.

In embodiments of this application, the positive electrode of the capacitor core package 150 is electrically connected to 153a in the two other input connection copper sheets 153a and 153b, 153a in the two other input connection copper sheets 153a and 153b is electrically connected to the input connection copper sheet 152a, and the input connection copper sheet 152a is electrically connected to the input copper bar 1341 of each power module 134. The negative electrode of the capacitor core package 150 is electrically connected to the other 153b in the two other input connection copper sheets 153a and 153b, the other 153b in the two other input connection copper sheets 153a and 153b is electrically connected to the other input connection copper sheet 152b, and the other input connection copper sheet 152b is electrically connected to the other input copper bar 1342 of each power module 134.

In embodiments of this application, the capacitor core package 150 is stacked between the two other input connection copper sheets 153a and 153b in the arrangement direction Z of the groove bottom 144 and the groove opening 142 of the accommodating groove 141, so that the positive and negative electrodes of the capacitor core package 150 can be in contact with the two other input connection copper sheets 153a and 153b respectively, to implement electrical connection. The input connection copper sheet 153a in the two other input connection copper sheets 153a and 153b is connected to the positive electrode of the capacitor core package 150. The other input connection copper sheet 153b in the two other input connection copper sheets 153a and 153b is connected to the negative electrode of the capacitor core package 150.

In an embodiment, as shown in FIG. 11, the two other input connection copper sheets 153a and 153b are integrated with the two input connection copper sheets 152 respectively. Specific shapes of the two other input connection copper sheets 153a and 153b are related to arrangement of the capacitor core package 150 in the accommodating groove 141.

In an embodiment, three power modules 134 in one power assembly 130 are respectively aligned with three power modules 134 in the other power assembly 130 in the width direction Y of the capacitor core package 150. As shown in FIG. 3, FIG. 8, and FIG. 11, each input connection copper sheet 152 includes three pairs of connection holes 154 and three pairs of avoidance holes 155, two connection holes 154a in each pair of connection holes 154 of the input connection copper sheet 152a each are configured to connect to one input copper bar 1341 of two power modules 134 that are aligned in the width direction Y of the capacitor core package 150, and two avoidance holes 155a in each pair of avoidance holes 155 of the input connection copper sheet 152a are respectively configured to pass through connectors that connect a pair of connection holes 154 of the other input connection copper sheet 152b and the other input copper bars 1342 of the two power modules 134. The three pairs of connection holes 154 and the three pairs of avoidance holes 155 in each input connection copper sheet 152 are alternately arranged in sequence in the length direction X of the capacitor core package 150. In the arrangement direction Z of the groove bottom 144 and the groove opening 142 of the accommodating groove 141, three pairs of connection holes 154 of the input connection copper sheet 152a are respectively aligned with three pairs of avoidance holes 155 of the other input connection copper sheet 152b.

In embodiments of this application, three power modules 134 in one power assembly 130 are respectively aligned with three power modules 134 in the other power assembly 130 in the width direction Y of the capacitor core package 150. This helps reduce space occupied by the two power assemblies 130 in the length direction X of the capacitor core package 150. Each input connection copper sheet 152 includes three pairs of connection holes 154 and three pairs of avoidance holes 155, so that each input connection copper sheet 152 can be electrically connected to a positive electrode or a negative electrode of each power assembly 130.

In embodiments of this application, two connection holes 154a in each pair of connection holes 154 of the input connection copper sheet 152a each are configured to connect to one input copper bar 1341 of two power modules 134 that are aligned in the width direction Y of the capacitor core package 150, and two avoidance holes 155a in each pair of avoidance holes 155 of the input connection copper sheet 152a are respectively configured to pass through connectors that connect a pair of connection holes 154 of the other input connection copper sheet 152b and the other input copper bars 1342 of the two power modules 134, so that the input connection copper sheet 152a can be electrically connected to the two power assemblies 130 stacked in the width direction Y of the capacitor core package 150. In addition, sharing the input connection copper sheet 152a and the other input connection copper sheet 152b can improve integration of the motor controller integrated module 100. Further, when being electrically connected to input copper bars 1341 of the two power modules 134 that are aligned in the width direction Y of the capacitor core package 150, each pair of connection holes 154 of the input connection copper sheet 152a can be free from electrical interference of a pair of connection holes 154 that is of the other input connection copper sheet 152b and that is connected to the other input copper bars 1342 of the two power modules 134.

As shown in FIG. 8 and FIG. 11, in embodiments of this application, three pairs of connection holes 154 and three pairs of avoidance holes 155 in each input connection copper sheet 152 are alternately arranged in sequence in the length direction X of the capacitor core package 150, each power assembly 130 includes three power modules 134, and the three power modules 134 are sequentially arranged and spaced apart in the length direction X of the capacitor core package 150, so that the three pairs of connection holes 154 and the three pairs of avoidance holes 155 of each input connection copper sheet 152 and input copper bars 1341 and the other input copper bars 1342 of the three power modules 134 of each power assembly 130 are stacked and connected in one-to-one correspondence.

In embodiments of this application, in the arrangement direction Z of the groove bottom 144 and the groove opening 142 of the accommodating groove 141, three pairs of connection holes 154 of the input connection copper sheet 152a are respectively aligned with three pairs of avoidance holes 155 of the other input connection copper sheet 152b, so that when being electrically connected to the input copper bar 1341 of each power module 134, the three pairs of connection holes 154 of the input connection copper sheet 152a are free from electrical interference of the other input connection copper sheet 152b. Similarly, three pairs of avoidance holes 155 of the input connection copper sheet 152a are aligned with three pairs of connection holes 154 of the other input connection copper sheet 152b, so that when being electrically connected to the other input copper bar 1342 of each power module 134, the three pairs of connection holes 154 of the other input connection copper sheet 152b are free from electrical interference of the input connection copper sheet 152a.

As shown in FIG. 11, in an embodiment, the two connection holes 154a in each pair of connection holes 154 are arranged in the width direction Y of the capacitor core package 150, and two avoidance holes 155a in a pair of avoidance holes 155 are arranged in the width direction Y of the capacitor core package 150. Each avoidance hole 155a is aligned with one connection hole 154a in the arrangement direction Z of the groove bottom 144 and the groove opening 142 of the accommodating groove 141. A hole diameter of each avoidance hole 155a is greater than a hole diameter of the connection hole 154a aligned with the avoidance hole.

As shown in FIG. 8 and FIG. 11, in embodiments of this application, the two connection holes 154a in each pair of connection holes 154 are arranged in the width direction Y of the capacitor core package 150, so that input copper bars 1341 of two power modules 134 aligned in the width direction Y of the capacitor core package 150 can be aligned in the width direction Y of the capacitor core package 150. Two avoidance holes 155a in a pair of avoidance holes 155 are arranged in the width direction Y of the capacitor core package 150, so that the other input copper bars 1342 of the two power modules 134 aligned in the width direction Y of the capacitor core package 150 can be aligned in the width direction Y of the capacitor core package 150. In this way, the two input connection copper sheets 152 can be electrically connected to the two power assemblies 130 stacked in the width direction Y of the capacitor core package 150.

In embodiments of this application, in the arrangement direction Z of the groove bottom 144 and the groove opening 142 of the accommodating groove 141, each avoidance hole 155a is aligned with one connection hole 154a, so that a process in which the connectors that connect the pair of connection holes 154 of the other input connection copper sheet 152b and the other input copper bars 1342 of the two power modules 134 pass through the two avoidance holes 155a in each pair of avoidance holes 155 of the input connection copper sheet 152a is smoother.

In embodiments of this application, the hole diameter of each avoidance hole 155a is greater than the hole diameter of the connection hole 154a aligned with the avoidance hole, so that an insulating separator 157 is conveniently inserted through each avoidance hole 155a, and an electrical connection between the two input connection copper sheets 152 is avoided.

In an embodiment, as shown in FIG. 11, two avoidance holes 155a in a pair of avoidance holes 155 arranged in the width direction Y of the capacitor core package 150 may communicate with each other, to form a groove 158. This helps save a copper sheet material.

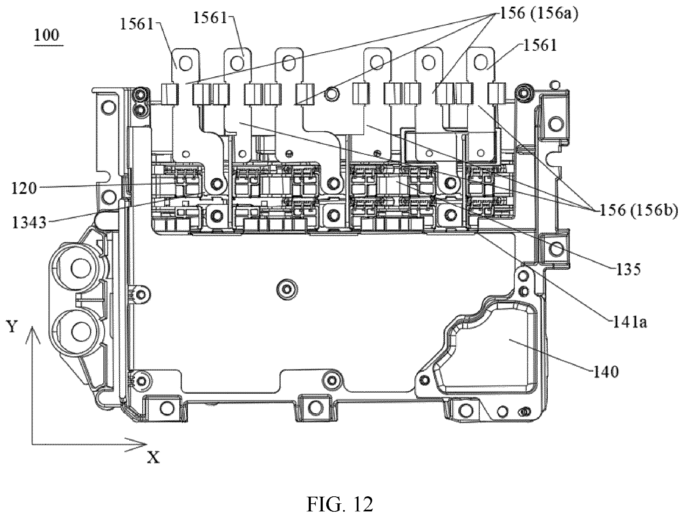

FIG. 12 is another diagram of a structure of a motor controller integrated module 100 according to an embodiment of this application.

In an embodiment, the output copper bar 1343 of each power module 134 is bent toward the first side wall 141a in the width direction Y of the capacitor core package 150. As shown in FIG. 10 and FIG. 12, the motor controller integrated module 100 further includes two groups of output connection copper sheets 156, one group of output connection copper sheets is denoted as 156a, and the other group of output connection copper sheets is denoted as 156b. Each group of output connection copper sheets 156 includes three output connection copper sheets 1561, and the three output connection copper sheets 1561 in each group of output connection copper sheets 156 each are configured to connect to one output copper bar 1343 of the three power modules 134 of each power assembly 130. As shown in FIG. 8 and FIG. 12, in the arrangement direction Z of the groove bottom 144 and the groove opening 142 of the accommodating groove 141, the three output connection copper sheets 1561 in each group of output connection copper sheets 156 and the output copper bar 1343 of each power module 134 are arranged on a same side and stacked on the two power assemblies 130 and the heat sink 120. The three output connection copper sheets 156 in each group of output connection copper sheets 1561 extend away from the first side wall 141a in the width direction Y of the capacitor core package 150. The three output connection copper sheets 1561 in the group of output connection copper sheets 156a and the three output connection copper sheets 1561 in the other group of output connection copper sheets 156b are alternately arranged in sequence in the length direction X of the capacitor core package 150.

In embodiments of this application, the output copper bar 1343 of each power module 134 is bent toward the first side wall 141a in the width direction Y of the capacitor core package 150. This helps reduce space occupied by the output copper bar 1343 of each power module 134 in the arrangement direction Z of the groove bottom 144 and the groove opening 142 of the accommodating groove 141. The two groups of output connection copper sheets 156 are configured to output or input a three-phase alternating current generated by the three power modules 134 of each of the two power assemblies 130.

In embodiments of this application, in the arrangement direction Z of the groove bottom 144 and the groove opening 142 of the accommodating groove 141, the three output connection copper sheets 1561 in each group of output connection copper sheets 156 and the output copper bar 1343 of each power module 134 are arranged on the same side, so that an alternating current output by the output copper bar 1343 of each power module 134 is smoothly output out of the motor controller integrated module 100 from the three output connection copper sheets 1561 through a short path. Each group of output connection copper sheets 156 is stacked on the two power assemblies 130 and the heat sink 120, so that each group of output connection copper sheets 156 is electrically connected to the output copper bar 1343 of each power module 134, and space occupied by each group of output connection copper sheets 156 in the width direction Y of the capacitor core package 150 and the length direction X of the capacitor core package 150 is further reduced.

In embodiments of this application, three output connection copper sheets 1561 in each group of output connection copper sheets 156 extend away from the first side wall 141a in the width direction Y of the capacitor core package 150, so that the three output connection copper sheets 1561 in each group of output connection copper sheets 156 output alternating currents in the motor controller integrated module 100 to a Hall copper bar component and the winding of the motor 12.

In embodiments of this application, three output connection copper sheets 1561 in the group of output connection copper sheets 156a and three output connection copper sheets 1561 in the other group of output connection copper sheets 156b are alternately arranged in sequence in the length direction X of the capacitor core package 150. This helps simplify connection arrangement between the two groups of output connection copper sheets 156 and the output copper bar 1343 of each power module 134 of the two power assemblies 130, and further helps shorten a connection path between the two groups of output connection copper sheets 156 and the output copper bar 1343 of each power module 134 of the two power assemblies 130, thereby saving copper bar materials.

As shown in FIG. 8 and FIG. 12, in an embodiment, the three output connection copper sheets 1561 in the group of output connection copper sheets 156a and the three output connection copper sheets 1561 in the other group of output connection copper sheets 156b are arranged in a flat manner in the length direction X of the capacitor core package 150, and the three output connection copper sheets 1561 in the other group of output connection copper sheets 156b are arranged in a bent manner to fit a design in which the two power assemblies 130 are stacked in the width direction Y of the capacitor core package 150.

As shown in FIG. 8 and FIG. 10, in an embodiment, each power module 134 further includes a plurality of signal connector cables 1344, the plurality of signal connector cables 1344 are configured to implement an electrical connection of each power module 134 in the motor controller integrated module 100, and the signal connector cables 1344 and the output copper bar 1343 of each power module 134 are arranged on a same side.

As shown in FIG. 8 and FIG. 12, in an embodiment, the motor controller integrated module 100 further includes a plurality of power module support members 135, and each power module support member 135 is configured to fasten one power module 134 to the housing 140 of the motor controller integrated module 100, so that power modules 134 of the two power assemblies 130 can be separately stacked, and have stationary positions. This helps improve stability of the motor controller integrated module 100.

In an embodiment, the motor controller integrated module 100 is further integrated with a circuit board 160. As shown in FIG. 5, the housing 140 is configured to fasten the circuit board 160. As shown in FIG. 5 and FIG. 8, in the arrangement direction Z of the groove bottom 144 and the groove opening 142 of the accommodating groove 141, the circuit board 160 is stacked on the housing 140, the heat sink 120, and each power module 134, and the circuit board 160, the groove bottom 144 of the accommodating groove 141, and the capacitor core package 150 are sequentially arranged.

In embodiments of this application, the housing 140 is configured to fasten the circuit board 160, and the circuit board 160 is supported by the housing 140, so that the circuit board 160 and the housing 140 have high stability. In this way, overall structural strength of the motor controller integrated module 100 is higher, and an electrical connection can be more stable. When an external environment exerts an external force on the motor controller integrated module 100, the circuit board 160 and the housing 140 are not prone to relative displacement. This helps the motor controller integrated module 100 operate in a stable state. The circuit board 160 is configured to bear an electrical component of the motor controller integrated module 100, so that the electrical component is more stably arranged in the motor controller integrated module 100.

In embodiments of this application, in the arrangement direction Z of the groove bottom 144 and the groove opening 142 of the accommodating groove 141, the circuit board 160 is stacked on the housing 140, the heat sink 120, and each power module 134, the circuit board 160, the groove bottom 144 of the accommodating groove 141, and the capacitor core package 150 are sequentially arranged, and the circuit board 160 is located on an outer side of the groove bottom 144 of the accommodating groove 141 of the housing 140, so that each power module 134 is plugged into the circuit board 160 through a signal connector cable 1344, to implement an electrical connection.

In an embodiment, an EMC filter 170 is further integrated into the motor controller integrated module 100, and the EMC filter 170 and the bus capacitor 110 are configured to perform filtering and voltage regulation on a direct current. As shown in FIG. 6, the peripheral groove wall of the accommodating groove 141 further includes two second side walls 141c and 141d, the two second side walls 141c and 141d are arranged oppositely in the length direction X of the capacitor core package 150, the capacitor core package 150 includes two groups of capacitor cores 151a and 151b, and the second side wall 141c, the group of capacitor cores 151a, the other group of capacitor cores 151b, and the other second side wall 141d are sequentially arranged in the length direction X of the capacitor core package 150. In the width direction Y of the capacitor core package 150, a length of the group of capacitor cores 151a is greater than a length of the other group of capacitor cores 151b. In the width direction Y of the capacitor core package 150, a part of another first side wall 1411 that is opposite to the other group of capacitor cores 151b is recessed toward the other group of capacitor cores 151b compared with another part of another first side wall 1412 that is opposite to the group of capacitor cores 151a, and space that is of the part of the another first side wall 1411 and that is away from the other group of capacitor cores 151b is used to accommodate the EMC filter 170.

In embodiments of this application, the EMC filter 170 can eliminate differential-mode interference and common-mode interference in a current signal, and reduce harmonic interference in the current signal. The EMC filter 170 and the bus capacitor 110 are configured to perform filtering and voltage regulation on a direct current, so that the motor controller integrated module 100 can transfer an accurate electrical signal to the winding of the motor 12, to drive the motor 12 to operate.

In embodiments of this application, the peripheral groove wall of the accommodating groove 141 further includes two second side walls 141c and 141d, the two second side walls 141c and 141d are arranged oppositely in the length direction X of the capacitor core package 150, the capacitor core package 150 includes two groups of capacitor cores 151a and 151b, and the second side wall 141c, the group of capacitor cores 151a, the other group of capacitor cores 151b, and the other second side wall 141d are sequentially arranged in the length direction X of the capacitor core package 150. In the length direction X of the capacitor core package 150, the two second side walls 141c and 141d electrically shield the two groups of capacitor cores 151a and 151b from another electrical component in the motor controller integrated module 100, so that the two groups of capacitor cores 151a and 151b work normally.

In embodiments of this application, in the width direction Y of the capacitor core package 150, the length of the group of capacitor cores 151a is denoted as L11, the length of the other group of capacitor cores 151b is denoted as L12, and L11>L12, so that the EMC filter 170 has space to be integrated into the motor controller integrated module 100, thereby helping improve integration of the power supply apparatus 15. In an embodiment, the two groups of capacitor cores 151a and 151b are horizontally placed in the width direction Y of the capacitor core package 150. In another embodiment, the two groups of capacitor cores 151a and 151b are vertically placed in the width direction Y of the capacitor core package 150, provided that L11>L12, so that the EMC filter 170 has sufficient space to be integrated into the motor controller integrated module 100.

In embodiments of this application, in the width direction Y of the capacitor core package 150, a part of another first side wall 1411 that is opposite to the other group of capacitor cores 151b is recessed toward the other group of capacitor cores 151b compared with another part of another first side wall 1412 that is opposite to the group of capacitor cores 151a, and space that is of the part of the another first side wall 1411 and that is away from the other group of capacitor cores 151b is used to accommodate the EMC filter 170. This helps fully utilize space in the motor controller integrated module 100 to integrate the EMC filter 170, and helps improve integration of the motor controller integrated module 100.

In an embodiment, the motor controller integrated module 100 is further integrated with a communication connector mounting hole 180. As shown in FIG. 4 and FIG. 5, the communication connector mounting hole 180 is configured to fasten a communication connector 181 that is in the power supply apparatus 15 and that is used to connect the vehicle controller to a vehicle-mounted load. The vehicle controller is configured to send a control signal to the power supply apparatus 15, to optimize vehicle energy distribution and vehicle operation.

The motor controller integrated module, the power supply apparatus, and the electric vehicle provided in embodiments of this application are described in detail above. The principle and embodiment of this application are described in this specification by using specific examples. The foregoing description about embodiments is merely provided to help understand the method and core ideas of this application. In addition, a person of ordinary skill in the art can make variations to this application in terms of the specific embodiments and application scope according to the ideas of this application. In conclusion, the content of this specification shall not be construed as a limitation on this application.

## Claims

1. A motor controller integrated module, wherein a bus capacitor, a heat sink, and two power assemblies are integrated into the motor controller integrated module, the bus capacitor comprises a housing and a capacitor core package, the housing is configured to fasten the heat sink and the two power assemblies, each power assembly is configured to implement mutual conversion between a direct current and a three-phase alternating current, the capacitor core package is configured to electrically connect to an end that is of each power assembly and that transmits the direct current, and the heat sink is configured to cool the two power assemblies, wherein
the housing comprises an accommodating groove, the accommodating groove is configured to accommodate the capacitor core package, a length of the capacitor core package in a width direction of the capacitor core package is less than a length of the capacitor core package in a length direction of the capacitor core package, a peripheral groove wall of the accommodating groove comprises two first side walls, and the two first side walls are opposite to each other in the width direction of the capacitor core package; and
the heat sink comprises a heat dissipation plate, in the width direction of the capacitor core package, the two power assemblies and the heat dissipation plate are stacked and arranged on a side that is of one first side wall and that is away from the other first side wall, each power assembly comprises three power modules, the three power modules are sequentially arranged and spaced apart in the length direction of the capacitor core package, and a thickness direction of each power module is parallel to the width direction of the capacitor core package.

2. The motor controller integrated module according to claim 1, wherein the length of the capacitor core package in the length direction of the capacitor core package is greater than a sum of lengths of the two power assemblies and the heat dissipation plate in the width direction of the capacitor core package.

3. The motor controller integrated module according to claim 1, wherein a length of the one first side wall in the length direction of the capacitor core package is greater than a distance between the two first side walls in the width direction of the capacitor core package, and the length of the one first side wall in the length direction of the capacitor core package is greater than a sum of lengths of the two power assemblies and the heat dissipation plate in the width direction of the capacitor core package.

4. The motor controller integrated module according to claim 1, wherein the capacitor core package, the one first side wall, one power assembly, the heat dissipation plate, and the other power assembly are sequentially arranged in the width direction of the capacitor core package.

5. The motor controller integrated module according to claim 1, wherein the heat sink further comprises a bottom plate, the bottom plate comprises two holes, and the two holes are used to communicate with an internal flow channel of the heat dissipation plate through an internal flow channel of the bottom plate, wherein
in the width direction of the capacitor core package, the bottom plate is arranged on a side that is of the two power assemblies and the heat dissipation plate and that is away from the capacitor core package; and
orientations of openings of the two holes are the same as an orientation of a groove opening of the accommodating groove.

6. The motor controller integrated module according to any one of claims 1 to 5, wherein the housing further comprises two fastening protrusions, the two fastening protrusions are configured to fasten an electrical component, the two fastening protrusions protrude from the one first side wall away from the capacitor core package in the width direction of the capacitor core package, and space between the two fastening protrusions is used to accommodate the heat sink and the two power assemblies, wherein
in the length direction of the capacitor core package, a distance between the two fastening protrusions is greater than a length of the heat sink or each power assembly; and
in the width direction of the capacitor core package, a length of each fastening protrusion is greater than a sum of lengths of the heat sink and the two power assemblies.

7. The motor controller integrated module according to any one of claims 1 to 5, wherein each power module comprises two input copper bars and one output copper bar, the two input copper bars are configured to electrically connect to the capacitor core package to receive a direct current, and the output copper bar is configured to output a one-phase alternating current, wherein
the two input copper bars are arranged opposite to the output copper bar in an arrangement direction of a groove bottom and the groove opening of the accommodating groove, the two input copper bars are on a same side as the groove opening of the accommodating groove, the two input copper bars of each power module are arranged and spaced apart in the length direction of the capacitor core package, and each input copper bar is bent toward the one first side wall in the width direction of the capacitor core package.

8. The motor controller integrated module according to claim 7, wherein the bus capacitor further comprises two input connection copper sheets, one input connection copper sheet is configured to electrically connect a positive electrode of the capacitor core package and one input copper bar of each power module, and the other input connection copper sheet is configured to electrically connect a negative electrode of the capacitor core package and the other input copper bar of each power module, wherein
in the arrangement direction of the groove bottom and the groove opening of the accommodating groove, the two input connection copper sheets are stacked and spaced apart in an insulating manner; and
in the arrangement direction of the groove bottom and the groove opening of the accommodating groove, the two input connection copper sheets are stacked on the two input copper bars of each power module.

9. The motor controller integrated module according to claim 8, wherein three power modules in one of the two power assemblies are respectively aligned with three power modules in the other of the two power assemblies in the width direction of the capacitor core package, each input connection copper sheet comprises three pairs of connection holes and three pairs of avoidance holes, two connection holes in each pair of connection holes of one input connection copper sheet each are configured to connect to one input copper bar of two power modules aligned in the width direction of the capacitor core package, and two avoidance holes in each pair of avoidance holes of the input connection copper sheet are respectively configured to pass through connectors that connect a pair of connection holes of the other input connection copper sheet and the other input copper bars of the two power modules, wherein
the three pairs of connection holes and the three pairs of avoidance holes in each input connection copper sheet are alternately arranged in sequence in the length direction of the capacitor core package; and
in the arrangement direction of the groove bottom and the groove opening of the accommodating groove, the three pairs of connection holes of the input connection copper sheet are respectively aligned with the three pairs of avoidance holes of the other input connection copper sheet.

10. The motor controller integrated module according to claim 9, wherein the two connection holes in each pair of connection holes are arranged in the width direction of the capacitor core package, and the two avoidance holes in one pair of avoidance holes are arranged in the width direction of the capacitor core package, wherein
each avoidance hole is aligned with one connection hole in the arrangement direction of the groove bottom and the groove opening of the accommodating groove; and
a hole diameter of each avoidance hole is greater than a hole diameter of the connection hole aligned with the avoidance hole.

11. The motor controller integrated module according to claim 7, wherein the output copper bar of each power module is bent toward the one first side wall in the width direction of the capacitor core package, the motor controller integrated module further comprises two groups of output connection copper sheets, each group of output connection copper sheets comprises three output connection copper sheets, and the three output connection copper sheets in each group of output connection copper sheets each are configured to connect to one output copper bar of the three power modules of each power assembly, wherein
in the arrangement direction of the groove bottom and the groove opening of the accommodating groove, the three output connection copper sheets in each group of output connection copper sheets and the output copper bar of each power module are arranged on a same side and stacked on the two power assemblies and the heat sink;
the three output connection copper sheets in each group of output connection copper sheets extend away from the one first side wall in the width direction of the capacitor core package; and
the three output connection copper sheets in one group of output connection copper sheets and the three output connection copper sheets in the other group of output connection copper sheets are alternately arranged in sequence in the length direction of the capacitor core package.

12. The motor controller integrated module according to any one of claims 1 to 5, wherein a circuit board is further integrated into the motor controller integrated module, and the housing is configured to fasten the circuit board, wherein
in the arrangement direction of the groove bottom and the groove opening of the accommodating groove, the circuit board is stacked on the housing, the heat sink, and each power module, and the circuit board, the groove bottom of the accommodating groove, and the capacitor core package are sequentially arranged.

13. The motor controller integrated module according to any one of claims 1 to 5, wherein an EMC filter is further integrated into the motor controller integrated module, the EMC filter and the bus capacitor are configured to perform filtering and voltage regulation on the direct current, the peripheral groove wall of the accommodating groove further comprises two second side walls, the two second side walls are arranged oppositely in the length direction of the capacitor core package, the capacitor core package comprises two groups of capacitor cores, and one second side wall, one group of capacitor cores, the other group of capacitor cores, and the other second side wall are sequentially arranged in the length direction of the capacitor core package, wherein
in the width direction of the capacitor core package, a length of the one group of capacitor cores is greater than a length of the other group of capacitor cores; and
in the width direction of the capacitor core package, a part of the other first side wall that is opposite to the other group of capacitor cores is recessed toward the other group of capacitor cores compared with another part of the other first side wall that is opposite to the one group of capacitor cores, and space that is of the part of the other first side wall and that is away from the other group of capacitor cores is used to accommodate the EMC filter.

14. A power supply apparatus, wherein the power supply apparatus comprises a housing and the motor controller integrated module according to any one of claims 1 to 13, and an internal flow channel of the housing is configured to communicate with an internal flow channel of the heat sink in the motor controller integrated module.

15. An electric vehicle, wherein the electric vehicle comprises a vehicle frame, a power battery, and the power supply apparatus according to claim 14, the vehicle frame is configured to fasten the power battery and the power supply apparatus, the bus capacitor in the motor controller integrated module of the power supply apparatus is configured to electrically connect to the power battery, and the power battery is configured to drive, by using a motor, a wheel of the electric vehicle to travel.
